# EUROPÄISCHE PATENTSCHRIFT

(11) **EP 1 318 539 B1**
(45) Veröffentlichungstag und Bekanntmachung des Hinweises auf die Patenterteilung: **28.12.2005**
(21) Anmeldenummer: 02023323.5
(22) Anmeldetag: 18.10.2002
(51) Int. Cl.: H01J 37/153

(54) **Korrektor zur Korrektion von Farbfehlern erster Ordnung, ersten Grades**
Corrector for the correction of first-order colour aberrations, first grade
Correcteur pour la correction d'aberrations couleur du premier ordre, premier grade

(30) Priorität: 04.12.2001 DE 10159454
(43) Veröffentlichungstag der Anmeldung: 11.06.2003
(73) Patentinhaber: Carl Zeiss NTS GmbH, 73446 Oberkochen (DE)
(72) Erfinder: Rose, Harald, 64287 Darmstadt (DE)
(74) Vertreter: Gnatzig, Klaus

(56) Entgegenhaltungen:
- DE-A- 4 204 512
- US-A- 3 952 198
- BARANOVA L A ET AL: "Minimisation of the aberrations of electrostatic lens systems composed of quadrupole and octupole lenses" INTERNATIONAL JOURNAL OF MASS SPECTROMETRY, ELSEVIER SCIENCE PUBLISHERS, AMSTERDAM, NL, Bd. 189, Nr. 1, 8. Juli 1999 (1999-07-08), Seiten 19-26, XP004171412 ISSN: 1387-3806
- ZACH J ET AL: "Aberration correction in a low voltage SEM by a multipole corrector" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A363, Nr. 1, 1995, Seiten 316-325, XP004009662 ISSN: 0168-9002

## Beschreibung

Die vorliegende Erfindung betrifft einen Korrektor zur Korrektion von Farbfehlern erster Ordnung, ersten Grades sowie geometrischer Aberrationen dritter Ordnung von elektronenoptischen Linsensystemen.

Ein entsprechender Korrektor ist aus der DE 42 04 512 A1 bekannt. Der Korrektor enthält insgesamt sechs Quadrupole, deren Potentiale antisymmetrisch zu einer Mittelebene erregt sind, und den Quadrupolen überlagerte Oktupole. Ein weiterer Oktupol ist in der Mittelebene angeordnet. Der Korrektor bildet ein teleskopisches System. Mit diesem Korrektor ist die Korrektur des Öffnungsfehlers dritter Ordnung und des axialen und des außeraxialen chromatischen Farbfehlers erster Ordnung, ersten Grades eines elektronenoptischen Linsensystems möglich. Eine Korrektur der Koma schiefer Bündel ist mit diesem System dadurch möglich, daß der komäfreie Punkt der zu korrigierenden Linse in den Knotenpunkt des Korrektors gelegt wird. Nicht korrigierbar sind mit diesem Korrektor außeraxiale geometrische Aberrationen dritter Ordnung, wie der Astigmatismus schiefer Bündel, die Verzeichnung und die Bildfeldwölbung. Insgesamt ist dieses Korrektiv damit nur für Systeme mit relativ kleinen Bildfeldern, wie beispielsweise in Transmissions-Elektronenmikroskopen üblich, einsetzbar, nicht hingegen in Verbindung mit Systemen die große Bildfelder erfordern, wie beispielsweise in der Elektronen-Projektionslithographie.

Es ist das Ziel der vorliegenden Erfindung, einen Korrektor anzugeben, mit dem sowohl die axialen und außeraxialen energieabhängigen Aberrationen erster Ordnung, ersten Grades eines elektronenoptischen Linsensystemes als auch der Öffnungsfehler dritter Ordnung korrigierbar ist und der auch für eine Korrektur der Verzeichnung, der Bildfeldwölbung und des Astimatismus schiefer Bündel des elektronenoptischen Linsensystemes erweiterbar ist. Bei vorteilhaften Ausführungsformen der Erfindung sollen auch die axialen und außeraxialen energieabhängigen Aberrationen erster Ordnung, zweiten Grades und sämtliche geometrischen Aberrationen dritter Ordnung zumindest für eine ausgezeichnete Ebene korrigierbar sein.

Das erstgenannte Ziel wird durch einen Korrektor mit den Merkmalen des Anspruches 1 gelöst. Vorteilhafte Ausgestaltungen der Erfindung ergeben sich aus den Merkmalen der abhängigen Ansprüche.

Der erfindungsgemäße Korrektor weist mindestens sieben Quadrupole, also ein Quadrupol-Septuplet, entlang einer geraden Achse auf, die symmetrisch zu einer Mittelebene entlang der geraden Achse erregbar sind. Weiterhin sind in dem erfindungsgemäßen Korrektor an verschiedenen Stellen innerhalb des Korrektors mindestens fünf Oktupolfelder erregbar.

Erfindungsgemäß wurde erkannt, daß bei einem System mit nur sieben Quadrupolen erreicht werden kann, daß alle axialen oder außeraxialen Fundamentalbahnen entweder symmetrisch oder antisymmetrisch zur Mittelebene des Korrektors verlaufen. Durch diese Symmetrie ist es möglich, den Öffnungsfehler zu korrigieren, ohne Koma und Verzeichnung zusätzlich einzuführen. Soweit das zu korrigierende elektronenoptische Linsensystem eine Koma aufweist, ist die Nullstelle der Feldbahnen des Korrektivs in den komafreien Punkt des Linsensystems bzw. der Linse zu legen, damit auch das Gesamtsystem frei von Koma ist.

Von den insgesamt sieben Quadrupolen sollten mindestens drei elektrisch-magnetisch sein, d.h. aus einer Überlagerung von elektrostatischen und magnetischen Qudrupolfeldern bestehen. Durch die elektrisch-magnetischen Qudrupole ist die Korrektur der axialen energieabhängigen Aberrationen möglich, ohne außeraxiale energieabhängige Aberrationen einzuführen. Aufgrund der Symmetrie der Quadrupole werden in der Knotenebene, in der die Feldstrahlen eine Nullstelle haben, keine außeraxialen energieabhängigen Aberrationen eingeführt. Diese Knotenebene bildet damit eine achromatische Ebene des Korrektors und gleichzeitig eine komafreie Ebene des Korrektors.

Ist eine Anordnung der Knotenebene des Korrektors in der achromatischen Ebene des zu korrigierenden Abbildungsystems nicht möglich, können außeraxiale energieabhängige Aberrationen auch durch eine geeignete Verteilung der magnetischen und elektrischen Quadrupolstärken erreicht werden, indem die elektrischen Quadrupolstärken einen zur Symmetrieebene des Septuplets antisymmetrischen Anteil aufweisen der betragsmäßig gleich aber von der Polarität invers zu einem zur Symmetrieebene des Septuplets antisymmetrischen Anteil der magnetischen Quadrupolstärken ist. Die gesamte Quadrupolstärke ist dann wieder symmetrisch zur Symmetrieebene des Septuplets. Der symmetrische Anteil der elektrischen und magnetischen Quadrupolstärken wird dann in ihrem Verhältnis zueinander so eingestellt, daß der axiale Farbfehler korrigiert wird und der antisymmetrische Anteil der elektrischen und magnetischen Quadrupolstärken wird in ihrem Verhältnis zueinander so eingestellt, daß die außeraxialen Farbfehler korrigiert werden.

Damit der Korrektor keine zusätzliche Koma und Verzeichnung einführt, sollten die Oktupole symmetrisch zur Mittelebene des Quadrupols Septuplets erregt sein.

Um die drei Komponenten des Öffnungsfehlers möglichst unabhängig voneinander zu korrigieren sollte ein erstes Oktupolpaar im Bereich des ersten und letzten Quadrupols, ein zweites Oktupolpaar im Bereich des zweiten und sechsten Quadrupels und ein weiterer Oktupol im Bereich des mittleren Quadrupols erregbar sein. Alternativ zur Erregung des Oktupols im Bereich des mittleren Quadrupols ist es jedoch auch möglich, ein weiteres Oktupolpaar im Bereich des dritten und fünften Quadrupols zu erregen. Eine besonders günstige Entkopplung der Komponenten des Öffnungsfehlers wird erreicht, wenn die Oktupolfelder den Quadrupolfeldern räumlich überlagert sind, dieses ist jedoch nicht zwingend erforderlich, insbesondere sind geringfügige Positionsabweichungen nicht kritisch.

Besonders vorteilhaft ist es, zwei geometrisch gleiche Quadrupol-Septuplets seriell hintereinander entlang der geraden Achse anzuordnen. Mit einer solchen Anordnung ist es dann möglich, alle geometrischen Aberrationen dritter Ordnung sowie die axialen energieabhängigen Aberrationen erster Ordnung, ersten Grades und erster Ordnung, zweiten Grades zu korrigieren. Eine besonders entkoppelte Korrektur aller geometrischen Aberrationen dritter Ordnung wird erreicht, wenn in der Mittelebene zwischen den Quadrupol-Septuplets ein weiterer Oktupol erregbar ist.

Der Korrektor hat zwei ausgezeichnete Anregungsmodi für die Oktupole: In einem ersten ausgezeichneten Anregungsmodus sind die Oktupolfelder in jedem Quadrupol-Septuplet symmetrisch zur Mittelebene des jeweiligen Qudrupol-Septuplets erregt und die Oktupole beider Quadrupol-Septuplets symmetrisch zur Mittelebene zwischen den Quadrupol-Septuplets erregt.

In diesem Betriebsmodus ist der Korrektor komafrei und verzeichnungsfrei, d.h. er führt keine zusätzliche Koma oder Verzeichnung ein.

Im zweiten ausgezeichneten Erregungsmodus sind die Oktupole in jedem Quadrupol-Septuplet antisymmetrisch zur Mittelebene des jeweiligen Quadrupol-Septuplets erregt und die Oktupolfelder beider Qudrupol-Septuplets antisymmetrisch zur Ebene zwischen den Qudrupol-Septuplets erregt. In diesem Betriebsmodus wird kein zusätzlicher Öffnungsfehler, keine Bildfeldwölbung und kein Astigmatismus schiefer Bündel vom Korrektor zusätzlich erzeugt. Welcher Betriebsmodus ausgewählt wird, hängt von den Symmetrieeigenschaften des zu korrigierenden elektronenoptischen Linsensystems ab. Da die Bildfeldwölbung und der Öffnungsfehler elektronenoptischer Rundlinsensysteme unvermeidbar sind, wird in der Praxis die Erregung der Oktupolfelder stets einen symmetrischen Anteil aufweisen. Durch geeignete Überlagerung eines symmetrischen und eines antisymmetrischen Anteils der Oktupolerregungen lassen sich die geometrischen Fehler dritter Ordnung beliebiger Rundlinsensysteme prinzipiell korrigieren.

Weiterhin vorteilhaft ist es, in der Mittelebene zwischen den Quadrupol-Septuplets einen weiteren Oktupol erregbar anzuordnen. Durch diesen zusätzlichen Oktupol zusammen mit den Erregungen der beiden Oktupole in den Symmetrieebenen der Qudrupol-Septuplets ist es möglich, den Öffnungsfehler weitgehend unabhängig von außeraxialen Bildfehlern zu korrigieren.

Weiterhin ist es vorteilhaft, die Oktupolfelder oder zumindest einen Teil der Oktupolfelder durch die Erregung von zwölf Polen oder Multipolen noch höherer Ordnung zu generieren, damit die Orientierung der Oktupolfelder elektrisch um die gerade Achse drehbar ist. Dadurch ist es möglich, die azimutalen Komponenten der Koma, des Astigmatismus schiefer Bündel und der Verzeichnung zu korrigieren.

Weiterhin ist es vorteilhaft, wenn zumindest ein Teil der Oktupolfeler elektisch-magnetisch sind, also ebenfalls aus einer Überlagerung von gekreuzten elektrischen und magnetischen Oktupolfeldern bestehen. Dadurch lassen sich die energieabhängigen Fehler erster Ordnung, dritten Grades teilweise korrigieren und damit reduzieren.

Weiterhin vorteilhaft ist es, sechszählige Multipolfelder zu erzeugen, um die dominanten geometrischen Fehler fünfter Ordnung zu korrigieren.

Die axialen und außeraxialen Fundamentalbahnen sollten beim Korrektor nach der vorliegenden Erfindung in jedem Quadrupol-Septuplet symmetrisch oder antisymmetrisch zur Mittelebene des jeweiligen Quadrupol-Septuplets sein.

Der Verlauf der Fundamentalbahnen im XZ-Schnitt des ersten Septuplets entspricht dem Verlauf der entsprechenden Fundamentalbahnen im YZ-Schnitt des zweiten Septuplets und umgekehrt (wie beim eingangs zitierten Stand der Technik DE 42 04 412).

Ein entsprechender Korrektor, mit dem sämtliche Fehler dritter Ordnung und die energieabhängigen Fehler erster Ordnung, ersten Grades korrigierbar sind, enthält mindestens 14 Quadrupolfelder und 15 Oktupolfelder, die entlang der geraden Achse an unterschiedlichen geeigneten Stellen erregbar sind.

Ein entsprechender Korrektor findet vorzugsweise Anwendung innerhalb eines elektronenoptischen Abbildungssystems, wie dieses beispielsweise in der Elektronen-Projektionslithographie angewendet wird, das eine erste Ebene in eine zweite Ebene verkleinert abbildet. Ein solches elektronenoptisches Abbildungssystem weist dann mindestens zwei Linsen auf, und der Korrektor ist zwischen diesen Linsen angeordnet.

Nachfolgend wir die Erfindung anhand der in den Figuren dargestellten Ausführungsbeispiele näher erläutert. Im einzelnen zeigen:
- Figur 1: eine Prinzipskizze eines ersten Ausführungsbeispiels des erfindungsgemäßen Korrektors mit dem Verlauf der Fundamentalbahnen innerhalb des Korrektors,
- Figur 2: die Prinzipskizze eines zweiten Ausführungsbeispiels eines Korrektors nach der Erfindung der aus zwei Korrektoren entsprechend der Figur 1 zusammengesetzt ist,
- Figur 3: die Prinzipskizze eines Elektronen-Projektionssystems mit einem Korrektor nach der vorliegenden Erfindung.

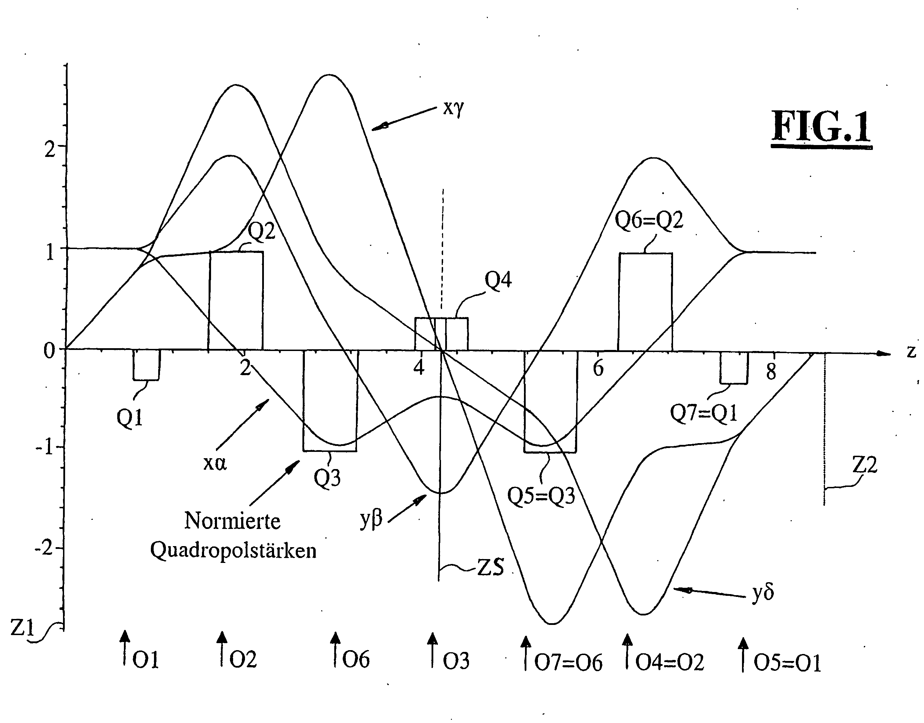

In der Figur 1 sind mit (Q1 - Q7) der Verlauf und die Stärken der entlang einer geraden Achse (Z) erregten Quadrupolfelder (Q1 - Q7) dargestellt. Die Quadrupole (Q1 - Q7) sind symmetrisch zur mittleren Symmetrieebene (ZS). Die Symmetrieebene (ZS) stellt dabei eine Symmetrieebene sowohl hinsichtlich der Qudrupolfelder als auch hinsichtlich der Fundamentalbahnen dar. Als Symmetrieebenen werden dabei Ebenen verstanden, bezüglich der die Quadrupolpotentiale symmetrisch und paraxiale Bahnen symmetrisch oder antisymmetrisch sind.

Ein Teil der Qudrupole (Q1 - Q7), mindestens 3 Quadrupolpaare in jeder der beiden zueinander symmetrischen Hälften des Korrektors, sollte elektrisch-magnetisch sein, also aus der Überlagerung von zueinander senkrechten elektrostatischen und magnetischen Quadrupolfeldern bestehen, um den axialen Farbfehler zu korrigieren. Geeignet dafür sind mit Ausnahme der beiden äußeren Qudrupole (Q1, Q7) alle übrigen Quadrupole, weil sich dort die Achsenabstände der axialen Fundamentalbahnen (Xα, Yβ) stark unterscheiden. Die Feldbahnen, bzw. außeraxialen Bahnen, sind in üblicherweise mit (Xγ) und (Yδ) bezeichnet. Die Feldbahnen (Xγ, Yδ) sind antisymmetrisch und die axialen Bahnen (Xα, Yβ) sind symmetrisch zur Symmetrieebene (ZS). Die Knotenebenen des teleskopischen Systems des Korrektors sind mit (Z1) bzw. (Z2) bezeichnet. Die Knotenebenen (Z1, Z2) zeichnen sich dadurch aus, daß ein in einer der Knotenebene befindliches Objekt im Abbildungsmaßstab 1:1 in die andere Knotenebene abgebildet wird.

Um die drei Komponenten des Öffnungsfehlers dritter Ordnung zu korrigieren, werden unter Beibehaltung der Symmetrie fünf Okutopole (O1 - O5) benötigt. Die Oktupole (O1 - O5) sind durch die entsprechend bezeichneten Pfeile angedeutet. Die Lagen der einzelnen Oktupole entlang der Achse (Z) sind in Bezug auf den Verlauf der Fundamentalbahnen so gewählt, daß sich die drei Komponenten des Öffnungsfehlers weitgehend unabhängig voneinander korrigieren lassen. Ein Oktupolpaar (O1, O5) ist an Stellen angeordnet, an denen der Strahl weitgehende Rotationssymmetrie hat, wie in Bereichen vor dem ersten Quadrupole (Q1) und hinter dem letzten Quadrupol (Q7). Aus bautechnischen Gründen ist es auch möglich die Oktupole dem ersten und letzten Quadrupol (Q1) und (Q7) zu überlagern. Dadurch wird auch eine Überlagerung des Oktupolfeldes mit einem Rundlinsenfeld vor bzw. hinter dem Korrektor vermieden. Weitere Oktupolpaare (O2, O4, O3) sind vorzugsweise in Bereichen astigmatischer Zwischenbilder gelegt, also den Nulldurchgängen einer der Fundamentalbahnen, weil dadurch eine die weitgehende Entkopplung der Fehlerkorrektur gewährleistet ist.

Anstelle eines Oktupols (O3) in der Symmetrieebene (ZS) können auch zwei Oktupole (O6, O7) dem dritten bzw. fünften Qudrupol überlagert sein, wie in der Figur 1 gestrichelt angedeutet. Weiterhin ist es möglich, den im Bereich der Symmetrieebene (ZS) angeordneten Qudrupol (Q4) in zwei räumlich getrennte Quadrupole aufzuspalten.

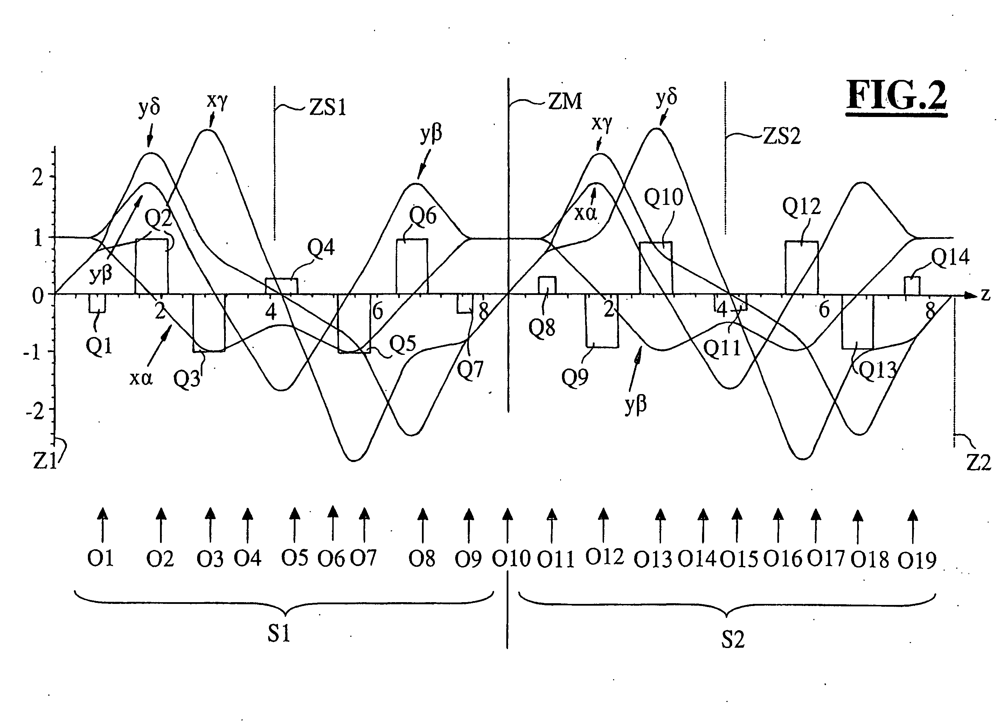

In der Figur 2 ist ein Gesamtsystem dargestellt, das aus zwei Quadrupol-Septuplet-Teilsystemen (S1, S2) entsprechend dem Quadrupol-Septuplet in Figur 1 aufgebaut ist. Jedes dieser Septuplet-Teilsysteme ist symmetrisch zur eigenen Septuplet-Symmetieebene (ZS1, ZS2) aufgebaut, beide Septuplet-Teilsysteme (S1, S2) sind jedoch hinsichtlich der Qudrupolstärken antisymmetrisch zur Mittenebene (ZM) des Gesamtsystems. Das Gesamtsystem hat insgesamt 14 Quadrupole (Q1 - Q14), und 19 Oktupole (O1 - O19). Die Oktupole sind auch hier wieder durch die Pfeile (O1-O19) angedeutet. Die Antisymmetrie des Gesamtsystems bezüglich der Mittelebene (ZM) bedingt eine Vertauschung der Fundamentalbahnen in den XZ- und YZ-Schnitten der beiden Teilsysteme, d.h. beispielsweise der Verlauf der Xα-Bahn im ersten Septuplet (S1) entspricht dem Verlauf der Yβ-Bahn im zweiten Septuplet (S2), und umgekehrt. Das analoge gilt für die Feldbahnen (Yδ) und (Xγ). In Ergänzung zur Figur 1 ermöglicht die Platzierung zusätzlicher Oktupole (O4, O6) zwischen dem dritten und vierten Quadrupol (Q3, Q4) und zusätzlich entsprechend der Symmetrie zwischen dem vierten und fünften Quadrupol (Q4, Q5) im ersten Septuplet (S1) und entsprechender symmetrischer Oktupole (O14) und (O16) im zweiten Septuplet (S2) sowie ein Oktupol (O10) in der Mittenebene (ZM) die vollständige Korrektur sämtlicher geometrischer Bildfehler dritter Ordnung. Aufgrund der größeren Anzahl möglicher elektrisch-magnetischer Quadrupole im Ausführungsbeispiel der Figur 2 und der erhöhten Symmetrie können bei diesem Ausführungsbeispiel auch die Farbfehler erster Ordnung, zweiten Grades korrigiert werden, so daß das Gesamtsystem apochromatisch wird.

Die Erregung der Quadrupolfelder erfolgt derart, daß diese eine Zweischnitt-Symmetrie haben, so daß die Hauptschnitte aller Quadrupole in einem gemeinsamen ebenen Schnitt liegen. Ein Schnitt ist dabei eine Fläche, in der die optische Achse liegt. Als Ebenen werden ebene Flächen verstanden, die senkrecht zur optischen Achse liegen, wie z.B. die Symmetrieebenen (ZS1, ZS2) und die Mittelebene (ZM). Durch die Einführung der Symmetrien in den Ebenen und Schnitten wird die Anzahl der linear unabhängigen Fehlerkoeffizienten dritter Ordnung des Quadrupolsystems in Figur 2 auf fünf linear unabhängige Koeffizienten reduziert. Aufgrund der Zweischnitt-Symmetrie hängen die Potentiale der Quadrupole von x² und y² ab (während Rundlinsenpotentiale nur von x² + y² abhängen). Aufgrund der Symmetrie/Antisymmetrie der Fundamentalbahnen verschwinden die azimutalen Fehlerkoeffizienten des Korrektors. In Folge der Antisymmetrie der Feldbahnen und der Symmetrie der axialen Bahnen bezüglich der Symmetrieebenen (ZS1, ZS2) verschwinden alle Terme, die die Summe der Exponenten der Feldbahnen ungerade enthalten, woraus resultiert, daß die Koma und die Verzeichnung sowie die Farbabhängigkeit der Vergrößerung des einzelnen symmetrischen Quadrupolsystems, d.h. eines einzelnen Quadrupol-Septuplets, verschwinden.

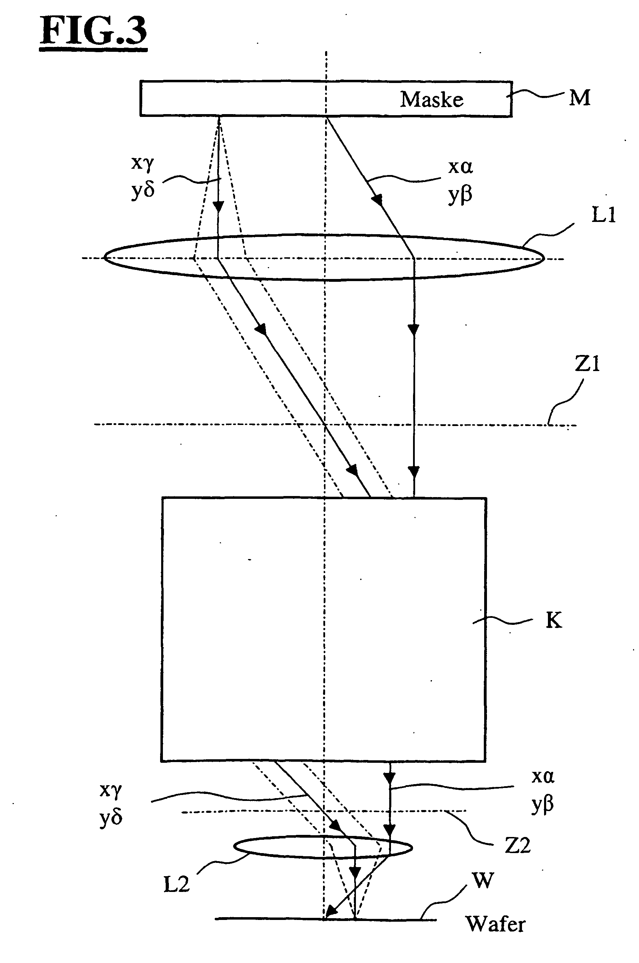

In der Figur 3 ist ein erfindungsgemäßer Korrektor in Verbindung mit einem telezentrischen Duplettsystem, wie es in der Elektronen-Projektionslithographie Anwendung findet, dargestellt. Das telezentrische Duplett enthält eine erste Magnetlinse (L1), in deren vorderen Brennebene die abzubildende Maske (M) angeordnet ist. Die vordere Knotenebene (Z1) des Korrektors fällt mit der hinteren Brennebene der ersten Linse (L1) zusammen. Auf den Korrektor (K) folgt eine zweite Magnetlinse (L2), deren vordere Brennebene mit der hinteren Knotenebene (Z2) des Korrektors (K) zusammenfällt. Das Bild (W) der Maske (M) entsteht in der hinteren Brennebene der zweiten Magnetlinse (L2), in der der zu belichtende Wafer zu positionieren ist. Die Vergrößerung bzw. Verkleinerung des Gesamtsystems ist durch das Verhältnis der Brennweiten der beiden Magnetlinsen (L1) und (L2) bestimmt. Durch Skalierung der Felder der beiden Linsen (L1, L2) entsprechend der Vergrößerung und durch entgegengesetzte Stromrichtungen in beiden Linsen verschwinden die Lamordrehung des Gesamtsystems sowie die isotropen und anisotropen Anteile der Verzeichnung und des Farbfehlers der Vergrößerung.

Durch den Korrektor (K) mit einem Aufbau wie dieser in Figur 2 dargestellt ist, sind sämtliche geometrischen Fehler dritter Ordnung sowie der Farbfehler erster Ordnung, ersten Grades sowie der Farbfehler erster Ordnung, zweiten Grades des Gesamtsystemes korrigierbar. Das Gesamtsystem stellt einen Apochromaten dar, der frei von sämtlichen geometrischen Bildfehlern dritter Ordnung ist. Dieser Apochromat ermöglicht die Abbildung großer Objektfelder bei gleichzeitig relativ großer Energiebreite der abbildenden Elektronen.

Bei der Realisierung des apochromatischen Systemes ist es günstig, den Farbfehler erster Ordnung, ersten Grades nicht vollständig auszukorrigieren, sondern so einzustellen, daß der Restfehler des Farbfehlers erster Ordnung, ersten Grades den verbleibenden Farbfehler erster Ordnung, dritten Grades für eine möglichst große Energiebandbreite möglichst klein hält.

## Patentansprüche

1. Korrektor zur Korrektur von energieabhängigen Aberrationen erster Ordnung, ersten Grades sowie des Öffnungsfehlers dritter Ordnung von elektronenoptischen Linsensystemen mit mindestens einem sieben Quadrupole (Q1 - Q7) enthaltenden Quadrupol-Septuplet, wobei die Quadrupole symmetrisch zu einer Mittelebene (ZS) entlang einer geraden Achse erregbar sind und mit mindestens fünf innerhalb des Quadrupol-Septuplets erregbaren Oktupolen (O1 - O7).

2. Korrektor nach Anspruch 1, wobei mindestens drei Quadrupole (Q2, Q4, Q6) elektrisch-magnetisch sind.

3. Korrektor nach Anspruch 1 oder 2, wobei die Oktupole (O1 - O7) symmetrisch zur Mittelebene (ZS) erregbar angeordnet sind.

4. Korrektor nach Anspruch 3, wobei ein erster und zweiter Oktupol (O1, O5) jeweils im Bereich des ersten und letzten Quadrupols (Q1, Q7), ein dritter und vierter Oktupol (O2, O4) jeweils im Bereich des zweiten und sechsten Quadrupols (Q2, Q6) und ein fünfter Oktupol (O5) im Bereich des mittleren Quadrupols (Q4) erregbar angeordnet sind.

5. Korrektor nach Anspruch 3, wobei ein erster und zweiter Oktupol (O1, O5) jeweils im Bereich des ersten und letzten Quadrupols (Q1, Q7), ein dritter und vierter Oktupol (O2, O4) jeweils im Bereich des zweiten und sechsten Quadrupols (Q2, Q6) und ein fünfter und sechster Oktupol (O6, O7) jeweils im Bereich des dritten und fünften Quadrupols (Q3, Q5) erregbar angeordnet sind.

6. Korrektor nach einem der Ansprüche 1 bis 5, wobei zwei geometrisch gleiche Quadrupol-Septuplets (S1, S2) seriell hintereinander entlang der geraden Achse (Z) angeordnet sind.

7. Korrektor nach Anspruch 6, wobei die Quadrupolfelder (Q1 - Q7, Q8 - Q14) des ersten und zweiten Quadrupol-Septuplets (S1, S2) antisymmetrisch zu einander erregbar angeordnet sind.

8. Korrektor nach Anspruch 6 oder 7, wobei in der Mittelebene (ZM) zwischen beiden Quadrupol-Septuplets (S1, S2) ein weiterer Oktupol (O10) erregbar angeordnet ist.

9. Korrektor nach einem der Ansprüche 6 bis 8, wobei die Oktupole (O1 - O19) in jedem Quadrupol-Septuplet (S1, S2) symmetrisch zur Mittelebene (ZS1, ZS2) des Quadrupol-Septuplets (S1, S2) und die Oktupole (O1 - O19) beider Quadrupol-Septuplets (S1, S2) symmetrisch zur Mittelebene (ZM) zwischen den Quadrupol-Septuplets (S1, S2) erregt sind.

10. Korrektor nach einem der Ansprüche 6 bis 8, wobei die Oktupole (O1 - O19) in jedem Quadrupol-Septuplet (S1, S2) antisymmetrisch zur Mittelebene (ZS1, ZS2) des Quadrupol-Septuplets (S1, S2) und die Oktupole (O1 - O19) beider Quadrupol-Septuplets (S1, S2) antisymmetrisch zur Mittelebene (ZM) zwischen den Quadrupol-Septuplets (S1, S2) erregt sind.

11. Korrektor nach einem der Ansprüche 6 bis 8, wobei die Erregung der Oktupole (O1-O19) in jedem Quadrupol-Septuplet (S1, S2) eine Überlagerung aus einer zur Mittelebene (ZS1, ZS2) des Quadrupol-Septuplets symmetrischen und antisymmentrischen Erregung ist und die Erregung der Oktupole (O1 - O19) beider Quadrupol-Septuplets (S1, S2) eine Überlagerung aus einer zur Mittelebene (ZM) zwischen den Quadrupol-Septuplets (S1, S2) symmetrischen und antisymmetrischen Erregung ist.

12. Korrektor nach einem der Ansprüche 6 - 11, wobei ein Teil der Oktupole (O1 - O19) als Zwölfpol oder höherer Multipol ausgebildet ist und die Orientierung der Oktupolfelder elektrisch um die gerade Achse (Z) drehbar ist.

13. Korrektor nach einem der Ansprüche 6 -12, wobei ein Teil der Oktupole (O1 - O19) elektrisch-magnetisch ist.

14. Korrektor nach einem der Ansprüche 6 -13, wobei in einem Teil der Okupole (O1-O19) zusätzlich sechszählige Felder erregbar sind.

15. Korrektor nach einem der Ansprüche 6-14, wobei die axialen und außeraxialen Fundamentalbahnen (Xα, Yβ, Yδ, Xγ) in jedem Quadrupol-Septuplet (S1, S2) symmetrisch oder antisymmetrisch zur Mittelebene (ZS1, ZS2) des Quadrupol-Septuplets (S1, S2) und im ersten und zweiten Quadrupol-Septuplet (S1, S2) antisymmetrisch zur Mittelebene (ZM) zwischen den Quadrupol-Septuplets (S1, S2) verlaufen.

16. Korrektor nach einem der Ansprüche 1 - 15, wobei mindestens vierzehn Quadrupole (Q1 - Q14) und fünfzehn Oktupole (O1 - O19) entlang der Achse (Z) erregbar sind.

17. Elekektronenoptisches Abbildungssystem mit einer elektronenoptischen Linsenanordnung (L1, L2), die eine erste Ebene in eine zweite Ebene abbildet und einen Korrektor (K) nach einem der Ansprüche 1 bis 16 aufweist.

18. Elektronenoptisches Abbildungssystem nach Anspruch 17, wobei die elektronenoptischen Linsenanordnung eine erste und eine zweite Linse (L1, L2) aufweist und der Korrektor (K) im Strahlengang zwischen der ersten und zweiten Linse (L1, L2) angeordnet ist.

## Claims

1. Corrector for correction of energy-dependent first-order, first-degree aberrations, and of the third-order aperture aberration of electron optical lens systems having at least a quadrupole septuplet including seven quadrupoles (Q1 - Q7), the quadrupoles being excitable symmetrically in relation to a central plane (ZS) along a straight axis, and having at least five octupoles (O1 - O7) excitable inside the quadrupole septuplet.

2. Corrector according to Claim 1, in which at least three quadrupoles (Q2, Q4, Q6) are electric/magnetic.

3. Corrector according to Claim 1 or 2, in which the octupoles (O1 - O7) are arranged excitably symmetrically in relation to the central plane (ZS).

4. Corrector according to Claim 3, in which a first and second octupole (O1, O5) are respectively arranged excitably in the region of the first and last quadrupole (Q1, Q7), a third and fourth octupole (O2, O4) are respectively arranged excitably in the region of the second and sixth quadrupole (Q2, Q6), and a fifth octupole (O5) is arranged excitably in the region of the central quadrupole (Q4).

5. Corrector according to Claim 3, in which a first and second octupole (O1, O5) are respectively arranged excitably in the region of the first and last quadrupole (Q1, Q7), a third and fourth octupole (O2, O4) are respectively arranged excitably in the region of the second and sixth quadrupole (Q2, Q6), and a fifth and sixth octupole (O6, O7) are respectively arranged excitably in the region of the third and fifth quadrupole (Q3, Q5).

6. Corrector according one of Claims 1 to 5, in which two geometrically identical quadrupole septuplets (S1, S2) are arranged serially one behind another along the straight axis (Z).

7. Corrector according to Claim 6, in which the quadrupole fields (Q1 - Q7, Q8 - Q14) of the first and second quadrupole septuplets (S1, S2) are arranged excitably and anti-symmetrically in relation to one another.

8. Corrector according to Claim 6 or 7, in which a further octupole (O10) is arranged excitably in the central plane (ZM) between the two quadrupole septuplets (S1, S2).

9. Corrector according to one of Claims 6 to 8, in which the octupoles (O1 - O19) in each quadrupole septuplet (S1, S2) are excited symmetrically in relation to the central plane (ZS1, ZS2) of the quadrupole septuplet (S1, S2), and the octupoles (O1 - O19) of the two quadrupole septuplets (S1, S2) are excited symmetrically in relation to the central plane (ZM) between the quadrupole septuplets (S1, S2).

10. Corrector according to one of Claims 6 to 8, in which the octupoles (O1 - O19) in each quadrupole septuplet (S1, S2) are excited anti-symmetrically in relation to the central plane (ZS1, ZS2) of the quadrupole septuplet (S1, S2), and the octupoles (O1 - O19) of the two quadrupole septuplets (S1, S2) are excited anti-symmetrically in relation to the central plane (ZM) between the quadrupole septuplets (S1, S2).

11. Corrector according to one of Claims 6 to 8, in which the excitation of the octupoles (O1 - O19) in each quadrupole septuplet (S1, S2) is a superimposition of a symmetrical and anti-symmetrical excitation in relation to the central plane (ZS1, ZS2) of the quadrupole septuplet and the excitation of the octupoles (O1 - O19) of the two quadrupole septuplets (S1, S2) is a superimposition of a symmetrical and anti-symmetrical excitation in relation to the central plane (ZM) between the quadrupole septuplets (S1, S2).

12. Corrector according to one of Claims 6 - 11, in which some of the octupoles (O1 - O19) are designed as a dodecupole or higher multipole, and the orientation of the octupole fields is electrically rotatable about the straight axis (Z).

13. Corrector according to one of Claims 6 - 12, in which some of the octupoles (O1 - O19) are electric/magnetic.

14. Corrector according to one of Claims 6 - 13, in which sextuple fields are additionally excitable in some of the octupoles (O1 - O19).

15. Corrector according to one of Claims 6 - 14, in which the axial and extra-axial fundamental tracks (Xα, Yβ, Yδ, Xγ) run symmetrically or anti-symmetrically in relation to the central plane (ZS1, ZS2) of the quadrupole septuplets (S1, S2) in each quadrupole septuplet (S1, S2) and run anti-symmetrically in relation to the central plane (ZM) between the quadrupole septuplets (S1, S2) in the first and second quadrupole septuplet (S1, S2).

16. Corrector according to one of Claims 1 - 15, in which at least fourteen quadrupoles (Q1 - Q14) and fifteen octupoles (O1 - O19) are excitable along the axis (Z).

17. Electron optical imaging system having an electron optical lens arrangement (L1, L2) which images a first plane into a second plane and has a corrector (K) according to one of Claims 1 to 16.

18. Electron optical imaging system according to Claim 17, in which the electron optical lens arrangement has a first and a second lens (L1, L2), and the corrector (K) is arranged in the beam path between the first and second lens (L1, L2).

## Revendications

1. Correcteur destiné à corriger les aberrations énergétiques de premier ordre, du premier degré ainsi que l'erreur d'ouverture du troisième ordre des systèmes de lentilles optoélectroniques comprenant au moins un septuplet de quadripôles comprenant sept quadripôles (Q1 - Q7), les quadripôles pouvant être excités symétriquement par rapport à un plan central (ZS) le long d'un axe droit et comprenant au moins cinq octopôles (O1 - O7) excitable à l'intérieur du septuplet de quadripôles.

2. Correcteur selon la revendication 1, au moins trois quadripôles (Q2, Q4, Q6) étant électromagnétiques.

3. Correcteur selon la revendication 1 ou 2, les octopôles (O1 - O7) étant disposés de manière à être excitables symétriquement par rapport au plan central (ZS).

4. Correcteur selon la revendication 3, un premier et un deuxième octopôle (O1, O5) étant respectivement disposés de manière excitable dans la zone du premier et du dernier quadripôle (Q1, Q7), un troisième et un quatrième octopôle (O2, O4) respectivement dans la zone du deuxième et du sixième quadripôle (Q2, Q6) et un cinquième octopôle (O5) dans la zone du quadripôle central (Q4).

5. Correcteur selon la revendication 3, un premier et un deuxième octopôle (O1, O5) étant respectivement disposés de manière excitable dans la zone du premier et du dernier quadripôle (Q1, Q7), un troisième et un quatrième octopôle (O2, O4) respectivement dans la zone du deuxième et du sixième quadripôle (Q2, Q6) et un cinquième et un sixième octopôle (O6, O7) respectivement dans la zone du troisième et du cinquième quadripôle central (Q4).

6. Correcteur selon l'une des revendications 1 à 5, deux septuplets de quadripôles (S1, S2) géométriquement identiques étant disposés en série l'un derrière l'autre le long de l'axe droit (Z).

7. Correcteur selon la revendication 6, les champs de quadripôles (Q1 - Q7, Q8, Q14) des premier et deuxième septuplets de quadripôles (S1, S2) étant disposés de manière à pouvoir être excité de façon antisymétrique les uns par rapport aux autres.

8. Correcteur selon la revendication 6 ou 7, un octopôle (O10) supplémentaire étant disposé de manière à pouvoir être excité dans le plan central (ZM) entre les deux septuplets de quadripôles (S1, S2).

9. Correcteur selon l'une des revendications 6 à 8, les octopôles (O1 - O19) dans chaque septuplet de quadripôles (S1, S2) étant excités symétriquement par rapport au plan central (ZS1, ZS2) du septuplet de quadripôles (S1, S2) et les octopôles (O1 - O19) des deux septuplets de quadripôles (S1, S2) symétriquement par rapport au plan central (ZM) entre les septuplets de quadripôles (S1, S2).

10. Correcteur selon l'une des revendications 6 à 8, les octopôles (O1 - O19) dans chaque septuplet de quadripôles (S1, S2) étant excités de manière antisymétrique par rapport au plan central (ZS1, ZS2) du septuplet de quadripôles (S1, S2) et les octopôles (O1 - O19) des deux septuplets de quadripôles (S1, S2) de manière antisymétrique par rapport au plan central (ZM) entre les septuplets de quadripôles (S1, S2).

11. Correcteur selon l'une des revendications 6 à 8, l'excitation des octopôles (O1 - O19) dans chaque septuplet de quadripôles (S1, S2) étant une superposition d'une excitation symétrique et antisymétrique par rapport au plan central (ZS1, ZS2) du septuplet de quadripôles et l'excitation des octopôles (O1 - O19) des deux septuplets de quadripôles (S1, S2) étant une superposition d'une excitation symétrique et antisymétrique par rapport au plan central (ZM) entre les septuplets de quadripôles (S1, S2).

12. Correcteur selon l'une des revendications 6 à 11, une partie des octopôles (O1 - O19) étant réalisée sous la forme d'un dodécapôle ou d'un multipolaire supérieur et l'orientation des champs d'octopôles pouvant être tournée électriquement autour de l'axe droit (Z).

13. Correcteur selon l'une des revendications 6 à 12, une partie des octopôles (O1 - O19) étant électromagnétique.

14. Correcteur selon l'une des revendications 6 à 13, des champs à six chiffres étant en plus excitables dans une partie des octopôles (O1 - O19).

15. Correcteur selon l'une des revendications 6 à 14, les trajectoires fondamentales (Xα, Yβ, Yδ, Yγ) axiales et hors d'axe dans chaque septuplet de quadripôles (S1, S2) s'étendant de manière symétrique ou antisymétrique par rapport au plan central (ZS1, ZS2) du septuplet de quadripôles (S1, S2) et, dans le premier et le deuxième septuplet de quadripôles (S1, S2), de manière antisymétrique par rapport au plan central (ZM) entre les septuplets de quadripôles (S1, S2).

16. Correcteur selon l'une des revendications 1 à 15, au moins quatorze quadripôles (Q1 - Q14) et quinze octopôles (O1 - O19) pouvant être excités le long de l'axe (Z).

17. Système d'imagerie optoélectronique comprenant un arrangement de lentilles optoélectroniques (L1, L2) qui représente un premier plan et un deuxième plan et présente un correcteur (K) selon l'une des revendications 1 à 16.

18. Système d'imagerie optoélectronique selon la revendication 17, l'arrangement de lentilles optoélectroniques présentant une première et une deuxième lentille (L1, L2) et le correcteur (K) étant disposé dans le trajet du rayon entre la première et la deuxième lentille (L1, L2).
